## Europäisches Patentamt
## European Patent Office
## Office européen des brevets

(11) Veröffentlichungsnummer: **0 098 379**
**B1**

(12) — **EUROPÄISCHE PATENTSCHRIFT**

(45) Veröffentlichungstag der Patentschrift:
**12.08.87**

(51) Int. Cl.⁴: **H 01 F 19/08, H 03 F 3/217**

(21) Anmeldenummer: **83105010.9**

(22) Anmeldetag: **20.05.83**

(54) Schaltverstärker.

(30) Priorität: **25.06.82 CH 3920/82**

(43) Veröffentlichungstag der Anmeldung:
**18.01.84 Patentblatt 84/3**

(45) Bekanntmachung des Hinweises auf die Patenterteilung:
**12.08.87 Patentblatt 87/33**

(84) Benannte Vertragsstaaten:
**CH DE FR GB LI NL**

(56) Entgegenhaltungen:
**EP-A-0 025 234**
**FR-A-2 029 913**

**INSTRUMENTS & EXPERIMENTAL TECHNIQUES,**
**Band 22, Nr. 4, Juli/August 1979, Teil 2, Seiten 1053-**
**1056, 1980 Plenum Publishing Corporation, New**
**York, USA. S.S. Vdovin: "Powerful high-voltage**
**pulsed transformer"**

(73) Patentinhaber: **BBC Aktiengesellschaft Brown,**
**Boveri & Cie., Haselstrasse, CH- 5401 Baden (CH)**

(72) Erfinder: **Furrer, Andreas, Im Feld, CH- 5237**
**Mönthal (CH)**

EP 0 098 379 B1

## Beschreibung

Bei der Erfindung wird ausgegangen von einem Schaltverstärker nach dem Oberbegriff des Patentanspruchs 1.

Schaltverstärker dieser Art können für grosse Ausgangsleistungen bei hoher Ausgangsspannung gebaut werden und weisen den guten Wirkungsgrad von Klasse-D-Verstärkern auf. Gegenüber den bisher gebräuchlichen Linearverstärkern, die mit Hochspannung gespeist werden und spezielle Verstärkerröhren mit relativ kurzer Betriebsdauer aufweisen, können Schaltverstärker mit vergleichbaren Kennwerten einfacherweise mit gleichgerichteter Netzspannung betrieben werden. Sie enthalten handelsübliche Halbleiterschaltelemente langer Lebensdauer und relativ kleine Uebertrager.

Mit dem Oberbegriff nimmt die Erfindung auf eine erprobte Ausführungsform eines Schaltverstärkers Bezug, die mit besonderem Vorteil als Modulator für die Senderöhre eines Rundfunksenders verwendet werden kann und in der DE-A- 2 935 445 beschrieben ist. Dieser Schaltverstärker enthält mehrere parallel betriebene Verstärkerstufen, von dene jede zwei Schaltstufen aufweist, sowie einen Signalwandler, der das Eingangssignal in zwei um 180° phasenverschobene Impulsfolgen mit dauermodulierten Impulsen wandelt. Jede Impulsfolge steuert die Schaltelemente in einer Schaltstufe der Verstärkerstufen, womit das Sättigen der Uebertrager Vermieden und eine 100%-Aussteuerung der Verstärkerstufen erreicht werden kann. Es versteht sich, dass bei dieser Betriebsweise jede Schaltstufe bzw. jeder Uebertrager während jeder Periode der Impulsfolgen einmal erregt wird.

Um die Anzahl der Schaltvorgänge zu verringern, ist auch schon vorgeschlagen worden (EP-AI 0 058 443) einen Signalwandler zu verwenden, der das Eingangssignal in eine Mehrzahl Impulsfolgenpaare wandelt, deren um 180° phasenverschobene Impulsfolgen aus Impulsen mit maximaler, durch die Sättigungszeit des Uebertragers begrenzter Dauer bestehen, wobei die Anzahl der Impulsfolgenpaare in Abhängigkeit vom analogen Eingangssignal moduliert wird.

Weiter ist schon vorgeschlagen worden (EP-AI 0 083 714) den Uebertrager als Gegentaktübertrager auszubilden, was ermöglicht, mit den beiden Impulsfolgen bzw. einem Impulsfolgenpaar den gleichen Uebertrager zu erregen und damit die Gesamtzahl der Uebertrager im Schaltverstärker zu halbieren.

Wie jeder Fachmann sofort erkennt, werden bei einem Schaltverstärker, unabhängig von der Art der Modulation oder der Erregung des Uebertragers, die Verluste im Verstärker und die Verzerrung des Ausgangssignals massgeblich vom Aufbau und von den Eigenschaften des Uebertragers bestimmt.

Die Erfindung, wie sie im Patentanspruch 1 definiert ist, löst die Aufgabe, einen Schaltverstärker mit einem Hochfrequenz-Breitbandübertrager mit einer Uebertragungsbandbreite im Bereich von 50 Hz bis 1 MHz anzugeben, der auch bei hohen Isolationsspannungen zwischen Primärund Sekundärwicklung im Bereich von 50 kV und für eine zu übertragende Impulsleistung von $\geq 30$ kW eine gute Kopplung gewährleistet.

Nachfolgend wird ein bevorzugtes Ausführungsbeispiel der Erfindung mit Hilfe der Figuren beschrieben. Es zeigen:

Fig. 1 das Prinzipschema eines Schaltverstärkers mit mehreren Verstärkerstufen,

Fig. 2 das Blockschaltbild einer Schaltstufe für unipolare Impulse,

Fig. 3 den Längsschnitt durch eine erprobte Ausführungsform eines Uebertragers und

Fig. 4 den Querschnitt längs der Linie A-A durch den Uebertrager gemäss der Fig. 3.

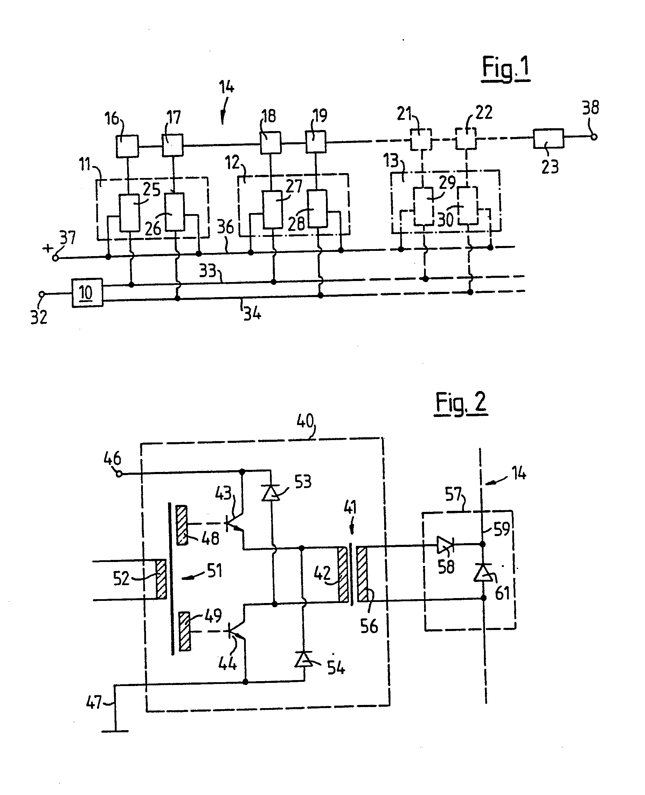

Der in Fig. 1 schematisch gezeigte Schaltverstärker enthält einen Impulsmodulator 10, eine Mehrzahl Verstärkerstufen 11, 12, 13, eine aus mehreren Gleichrichteranordnungen 16, 17, 18, 19 und 21, 22 gebildeten Serieschaltung 14, sowie ein Tiefpassfilter 23. Jeder Verstärkerstufe sind zwei Schaltstufen 25, 26; 27, 28 bzw. 29, 30 zugeordnet. Weiter enthält dieser Schaltverstärker eine Eingangsklemme 32 für das zu verstärkende analoge Eingangssignal, zwei Steuersignalleitungen 33, 34 von denen jede einen Signalausgang des Impulsmodulators 10 mit dem Signaleingang einer Schaltstufe in jeder Verstärkerstufe verbindet, eine Speisespannungsleitung 36, die die Speisespannungsquelle 37 mit dem Speisespannungseingang jeder Schaltstufe verbindet und eine an den Ausgang des Tiefpassfilters 23 angeschlossene zum Abnehmen des verstärkten analogen Ausgangssignals vorgesehene Ausgangsklemme 38.

Die in Fig. 2 gezeigte Ausführungsform einer Schaltstufe 40 enthält einen Uebertrager 41. Die Anschlüsse der Primärwicklung 42 des Uebertragers sind über Schalttransistoren 43, 44 mit einer Speisespannungsleitung 46 bzw. mit einer Masseleitung 47 verbunden. Die Steuerelektrode des Schalttransistors ist an eine Sekundärwicklung 48 bzw. 49 eines Steuersignaltransformators 51 angeschlossen, dessen Primärwicklung 52 mit einer der in Fig. 1 gezeigten Steuersignalleitungen 33 bzw. 34 verbunden ist. Parallel zur primärwicklung 42 des Uebertragers und zu je einem der Schalttransistoren 43, 44 ist noch eine Diode 53 bzw. 54 geschaltet, die den zugeordneten Schalttransistor beim Unterbrechen des Stroms gegen Ueberspannung schützt.

An die Sekundärwicklung 56 des Uebertragers ist eine Gleichrichteranordnung 57 angeschlossen, die den einen anschluss der Wicklung direkt und den anderen anschluss über eine Diode 58 mit der Leitung 59 der in Fig. 1 gezeigten Serieschaltung 14 verbindet, welche Serieschaltung zwischen den beiden Verbindungspunkten eine weitere Diode 61 aufweist.

Beim Betrieb des beschriebenen Schaltverstärkers wird das zu verstärkende Analogsignal über die Eingangsklemme 32 an den Impulsmodulator 10 geleitet. Am Ausgang des Impulsmodulators erscheinen dann zwei Impulsfolgen mit dauermodulierten, um 180° phasenverschobenen Impulsen. Jede Impulsfolge wird über eine der Steuersignalleitungen 33 bzw. 34 an den Steuersignaleingang einer der Schaltstufen, z.B. der Schaltstufen, 25, 27, 29 bzw. 26, 28, 30 in den Verstärkerstufen 11, 12 bzw. 13 geleitet. In der Schaltstufe wird die Impulsfolge vom Steuersignaltransformator 51 in Steuersignale für die beiden Schalttransistoren 43, 44 gewandelt. Der Anschluss der Steuerelektrode der Schalttransistoren an die Sekundärwicklung des Transformators ist derart gewählt, dass die Schalttransistoren während der Dauer jedes Impulses in den leitfähigen Zustand geschaltet werden und von der Speisespannungsleitung 46 ein Strom durch die Primärwicklung 42 des Uebertragers fliesst. Der in der Sekundärwicklung des Uebertragers induzierte Strom wird über die Gleichrichteranordnung 57 als einseitiger Impuls an die Serieschaltung 14 abgegeben. Am Eingang des Tiefpassfilters 23 erscheint dann ein Signal, das der Ueberlagerung aller von den Schaltstufen und Gleichrichteranordnungen erzeugten einseitigen Impulse entspricht. Am Ausgang des Tiefpassfilters kann dann ein verstärktes Analogsignal abgenommen werden.

Diese Betriebsweise ist in der einleitend genannten deutschen Offenlegungsschrift ausführlich dargestellt, weshalb hier auf eine weitere Beschreibung verzichtet wird.

Eine erprobte Ausführungsform dieses Schaltverstärkers wurde als Modulationsverstärker für einen Rundfunksender verwendet. Dieser Schaltverstärker enthielt 48 Verstärkerstufen mit je zwei Schaltstufen und ermöglicht, mit einer Speisespannung von 500 V_ bei einem Uebertragungsverhältnis von 1: 1,2 am Ende der Serieschaltung, d.h. am Eingang des Tiefpassfilters, Impulse mit einer Spitzenspannung von 28 kV und einer Leistung von 1400 kW zu erzeugen.

Für einen Schaltverstärker mit vorgebener Ausgangsleistung und -spannung ist die Anzahl der erforderlichen Verstärker- bzw. Schaltstufen, sowie die höchstmögliche Speisespannung durch die Strom-und die Spannungsfestigkeit der Schaltelemente gegeben. Bei Schaltverstärkern mit grosser Ausgangsleistung und -spannung und mit einer entsprechend grossen Anzahl Schaltstufen unterliegt der zu jeder Schaltstufe gehörende Uebertrager Betriebsbedingungen, die von den bisher gebräuchlichen Uebertragern nicht erfüllt werden. Wie bereits beschrieben wurde, werden beispielsweise die von den Schaltstufen übertragenen Impulse längs der Serieleitung überlagert, was zur Folge hat, dass die Spannungsdifferenz zwischen der Sekundär- und der Primärwicklung des in der Serieleitung letzten Uebertragers (in Fig. 1 des Uebertragers in der Schaltstufe 30) praktisch der Ausgangsspannung des Schaltverstärkers entspricht. Weiter wird beim Einschalten des Stroms durch die Primärwicklung des in der Serieleitung ersten Uebertragers (in Fig. 1 des Uebertragers in der Schaltstufe 25) von dem in der Sekundärwicklung induzierten Strom die Kapazität aller Uebertrager in der Serieschaltung aufgeladen, wobei der Ladestrom den für das Schaltelement bzw. die Schaltelemente im Primärkreis zulässigen Strom nicht übersteigen darf. Schliesslich muss der Uebertrager zum Uebertragen eines breiten Frequenzbandes von beispielsweise 50 Hz bis 1 MHz geeignet sein und soll innerhalb der Aussteuerungsgrenzen möglichst geringe nichtlineare Verzerrungen (Klirrfaktor) aufweisen.

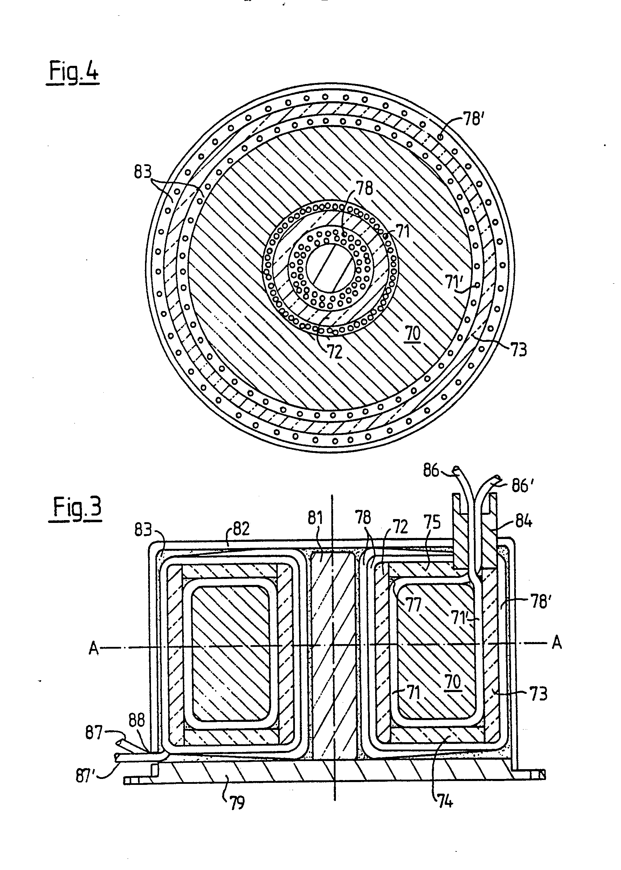

Die Figuren 3 und 4 zeigen den Längs- und den Querschnitt durch einen Uebertrager der für die Verwendung in einem mehrstufigen Schaltverstärker grosser Ausgangsleistung besonders gut geeignet ist. Der Uebertrager enthält einen schwimmenden Ringkern 70, auf den eine Sekundärwicklung 71, 71' aufgewickelt ist. Die Sekundärwicklung ist von einem isolierenden Gehäuse eingeschlossen, das aus einem inneren und einem äusseren Zylinder 72 bzw. 73 und einer ringförmigen Boden- und einer ebensolchen Deckplatte 74 bzw. 75 besteht. Der Innenraum des Gehäuses und der Raum zwischen den Windungen der Sekundärwicklung ist mit einer Isoliermasse 77 ausgegossen. Auf das isolierende Gehäuse sind die Windungen einer Primärwicklung 78, 78' aufgewickelt. Das Wicklungspaket steht auf einer Bodenplatte 79, und in dem von dem Wicklungspaket umschlossenen zylindrischen Innenraum ist ein Dorn 81 angeordnet, der gut wärmeleitend mit der Bodenplatte verbunden ist. Das Wicklungspaket ist von einer Abdeckhaube 82 eingeschlossen, deren freier Rand an der Bodenplatte befestigt ist. Der Raum zwischen den Windungen der Primärwicklung 78, 78', zwischen der Primärwicklung und dem Dorn 81 sowie der Innenwand der Abdeckhaube 82 ist ebenfalls mit einer Isoliermasse 83 ausgegossen. Der Uebertrager enthält weiter eine Isolierhülse 84 für die isolierte Ein- und Ausführung der beiden Enden 86, 86' der Sekundärwicklung, welche Hülse in eine Bohrung in der Abdeckhaube und zwischen zwei Windungen der Primärwicklung in die Deckplatte des isolierenden Gehäuses eingesetzt ist. Für die Ein- und Ausführung der Enden 87, 87' der Primärwicklung ist in der Abdeckhaube eine Oeffnung 88 vorgesehen.

Bei einer erprobten Ausführungsform des beschriebenen Uebertragers war der schwimmende Kern als Ringkern aus Ferritmaterial mit kleiner Remanenz ausgebildet. Der mittlere Durchmesser des Ringkerns betrug 11 cm, die Querschnittsfläche 27 cm$^2$. Die auf den

schwimmenden Ringkern gewickelte Sekundärwicklung bestand aus etwa 40 Windungen HF-Litze mit einem Durchmesser von 5 mm. Für das isolierende Gehäuse zwischen der Sekundär- und der Primärwicklung wurde ein spezielles Giessharz verwendet, mit einem sehr kleinen Verlustwinkel tg δ und einer relativ grossen Dielektrizitätskonstante. Die auf dem isolierenden Gehäuse und damit über der Sekundärwicklung angeordnete Primärwicklung bestand aus etwa 35 Windungen HF-Litze, ebenfalls mit einem Durchmesser von 5 mm. Zum Ableiten der Verlustwärme an die Bodenplatte wurde ein Dorn aus Aluminium verwendet mit einem Durchmesser von 3 cm. Nach dem Einlegen des mit den Windungen versehenen Ringkerns in das Gehäuse, war der Uebertrager in bekannter Weise in einer Vakuumanlage mit einem Isoliermaterial hoher Isolation vergossen worden.

Mit dem beschriebenen Uebertrager konnten uni- und bipolare Impulse in einem Frequenzbereich von 50 Hz bis 1 MHz übertragen werden. Die Impulsleistung betrug bei einer Aussteuerung des Uebertragers von 1:1 und bei einer Spannung von 500 V bis 30kW. Die Ableitung der Verlustwärme war auch bei hoher Belastung des Uebertragers gut. Die Kapazität zwischen der Sekundärwicklung und dem schwimmenden Ringkern beeinflusste die Uebertragung der Impulse praktisch nicht. Weil zwischen der Primär- und der Sekundärwicklung keine elektrische Abschirmung angeordnet ist, entstanden praktisch auch keine Wirbelstromverluste.

Es versteht sich, dass ein Uebertrager mit den geforderten Eigenschaften nicht notwendigerweise die in den Figuren gezeigte Form oder die beschriebenen Abmessungen aufweisen oder mit den beschriebenen Materialien hergestellt werden muss. Beispielsweise ist es möglich, anstelle eines einstückigen Ringkerns aus Ferritmaterial auch einen aus dünnen Ringkernbändern gewickelten Kern oder anstelle der beschriebenen HF-Litze entsprechende Flachbänder zu verwenden oder auf den zur besseren Ableitung der Verlustwärme vorgesehenen axialen Dorn zu verzichten.

Für Verstärkerstufen mit nur einer Schaltstufe ist es möglich, die Primärwicklung mit einem Mittelabgriff zu versehen und die beiden Enden der Wicklung über Schaltelemente, die um 180° phasenverschoben angesteuert werden, mit der Speisespannungsquelle zu verbinden. Wahlweise ist es auch möglich jedes Ende der Primärwicklung mit einem ersten Schaltelement mit der positiven Klemme und mit einem zweiten Schaltelement mit der negativen Klemme der Speisespannungsquelle zu verbinden und die den Stromfluss in der einen oder in der anderen Richtung ermöglichenden Schaltelemente paarweise anzusteuern. Bei dieser letzteren Ausführungsform ist der Mittelabgriff der Primärwicklung nicht erforderlich.

**Patentanspruch**

Schaltverstärker
a) mit einem Signalwandler (10), der ein zu verstärkendes Eingangssignal in mindestens zwei Impulsfolgen wandelt,
b) mit mehreren Verstärkerstufen (11, 12, 13), von denen jede mindestens eine Schaltstufe (40) zur Verstärkung der entsprechenden Impulsfolge aufweist,
c) wobei jede Schaltstufe wenigstens ein Schaltelement (43, 44) und
d) einen Uebertrager (41) aufweist,
e) dessen Primärwicklung (42; 78, 78') über dieses wenigstens eine Schaltelement mit einer Speisespannungsquelle (46) in Wirkverbindung steht,
f) wobei dieses Schaltelement von einer dieser beiden Impulsfolgen gesteuert ist,
g) wobei die Sekundärwicklung (56; 71, 71') des Uebertragers (41) von dessen Primärwicklung galvanisch getrennt und mit den Sekundärwicklungen der anderen Schaltstufen in Reihe geschaltet ist,
h) mit einem Tiefpassfilter (23), das an die Reihenschaltung der Sekundärwicklungen der Schaltstufen angeschlossen ist, um die in den Schaltstufen verstärkten Impulsfolgen zu einem verstärkten Ausgangssignal zu wandeln,
dadurch gekennzeichnet,
i) dass jeder Uebertrager (41) einen potentialmässig schwimmenden Ringkern (70) aus Ferritmaterial oder dünnen Ringkernbändern mit kleiner Remanenz und einer querschnittsfläche von $\geq$ 20 cm$^2$ aufweist,
j) dass die Sekundärwicklung (56, 71, 71') jedes Uebertragers mehrere auf den entsprechenden Ringkern gewickelte Windungen aus HF-Litze oder aus Flachbändern aufweist,
k) dass die Sekundärwicklung (56, 71, 71') von einem isolierenden Gehäuse (72, 73,74,75) mit einer Spannungsfestigkeit von mindestens 50 kV umgeben ist,
l) dass der Innenraum des Gehäuses und der Raum zwischen den Windungen der Sekundärwicklung mit einer Isoliermasse mit einem sehr kleinen Verlustwinkel (tg δ) und einer relativ grossen Dielektrizitätskonstante ausgegossen ist,
m) dass die Primärwicklung (42, 78, 78') des Uebertragers auf das isolierende Gehäuse aufgewickelt ist und mehrere Windungen aus HF-Litze oder aus Flachbändern aufweist,
n) dass ein Aussengehäuse (79, 82) diesen Uebertrager umschliesst und mit einem Isoliermaterial (83) hoher Isolation aufgefüllt ist und
o) dass in der Mitte dieses Ringkerns (70) ein Dorn (81) aus einem gut wärmeleitenden Material vorgesehen ist.
p) wobei die einzelnen Merkmale derart aufeinander abgestimmt sind daß jeder der Uebertrager zum Uebertragen von uni- und von bipolaren Impulsen und mit einer Uebertragungsbandbreite von 50 Hz bis 1 MHz geeignet ist und zwischen der Primär- (42, 78, 78') und der Sekundärwicklung (56, 71, 71') eine Spannungsfestigkeit von mindestens 50 kV, einen Kopplungskoeffizienten von mindestens 0,999 und eine Kapazität von weniger als 250 pF aufweist und bei einer Aussteuerung von 1:1 und einer Spannung von 500 V_ an der Primärwicklung eine Impulsleistung von mindestens 30 kW überträgt.

## Claim

1. Switching amplifier
   a) comprising a signal convertor (10) which converts an input signal to be amplified into at least two pulse trains,
   b) comprising several amplifier stages (11, 12, 13) each of which has at least one switching stage (40) for amplifying the corresponding pulse train,
   c) in which arrangement each switching stage has at least one switching element (43, 44) and
   d) a transformer (41),
   e) the primary winding (42; 78, 78') of which is effectively connected to a supply voltage source (46) via this at least one switching element,
   f) in which arrangement this switching element is controlled by one of these two pulse trains,
   g) in which arrangement the secondary winding (56; 71, 71') of the transformer (41) is isolated with respect to direct current from its primary winding and is connected in series with the secondary windings of the other switching stages,
   h) comprising a low-pass filter (23) which is connected to the series circuit of the secondary windings of the switching stages in order to convert the pulse trains amplified in the switching stages into an amplified output signal,
      characterized in that
   i) each transformer (41) has a ring core (70), which is floating with respect to potential, of ferrite material or thin ring core bands with low remanence and a crosssectional area of $\geq 20$ cm$^2$,
   j) the secondary winding (56, 71, 71') of each transformer has several turns of RF litz wire or of flat bands wound onto the corresponding ring core,
   k) the secondary winding (56, 71, 71') is surrounded by an insulating housing (72, 73, 74, 75) having a breakdown voltage of at least 50 kV,
   l) the internal space of the housing and the space between the turns of the secondary winding is cast with an insulating compound having a very low loss angle (tg δ) at a relatively large dielectric constant,
   m) the primary winding (42, 78, 78') of the transformer is wound onto the insulating housing and has several turns of RF litz wire or of flat bands
   n) an external housing (79, 82) encloses this transformer and is filled with a high-insulation insulating material (83) and
   o) a mandrel (81) of a material of good thermal conductivity is provided in the centre of this ring core (70),
   p) in which arrangement the individual features are matched to each other in such a manner that each of the transformers is suitable for transferring uni- and bipolar pulses and with a transfer band width of 50 Hz to 1 MHz and has between the primary winding (42, 78, 78') and the secondary winding (56, 71, 71') a breakdown voltage of at least 50 kV a coupling coefficient of at least 0.999 and a capacitance of less than 250 pF and transfers a pulse power of at least 30 kW with a modulation of 1:1 and a voltage of 500 VDC across the primary winding.

## Revendication

1. Amplificateur de commutation comportant
   a) un convertisseur de signaux (10) qui convertit un signal d'entrée à amplifier en au moins deux séquences d'impulsions;
   b) plusieurs étages d'amplification (11, 12, 13) qui comprennent chacun au moins un étage de commutation (40) pour amplifier la séquence d'impulsions correspondante;
   c) chaque étage de commutation comprenant au moins un élément de commutation (43, 44), et
   d) un transformateur (41);
   e) dont l'enroulement primaire (42; 78, 78') est en liaison active par l'intermédiaire de ce au moins un élément de commutation avec une source de tension d'alimentation (46);
   f) cet élément de commutation étant commandé par une de ces deux séquences d'impulsions;
   g) l'enroulement secondaire (56; 71, 71') du transformateur (1) étant séparé galvaniquement de son enroulement primaire et étant connecté en série avec les enroulements secondaires des autres étages de commutation;
   h) un filtre passe-bas (23) qui est connecté dans le montage en série des enroulements secondaires des étages de commutation pour convertir en un signal de sortie amplifié les séquences d'impulsions amplifiées dans les étages de commutation;
      caractérisé en ce que:
   i) chaque transformateur (41) comporte un noyau annulaire flottant quant à son potentiel (70) en matière ferritique ou en de minces rubans de noyau annulaire à faible rémanence et d'une aire en coupe $\geq 20$ cm$^2$;
   j) l'enroulement secondaire (56; 71, 71') de chaque transformateur comporte plusieurs spires en fil à brins multiples haute fréquence ou en ruban plat bobiné sur le noyau annulaire correspondant;
   k) l'enroulement secondaire (56; 71, 71') est entouré par un boîtier isolant (72, 73, 74, 75) présentant une rigidité diélectrique d'au moins 50 kV;

l) l'espace intérieur du boîtier et l'espace prévu entre les spires de l'enroulement secondaire est rempli d'une matière isolante coulée présentant un angle de perte tg δ très petit et une constante diélectrique relativement grande;

m) l'enroulement primaire (42; 78, 78') du transformateur est bobiné sur le boîtier isolant et comporte plusieurs spires en fil à brins multiples haute fréquence ou en ruban plat;

n) un boîtier extérieur (79; 82) entoure ce transformateur et est rempli d'une matière isolante (83) à haut pouvoir d'isolement, et

o) au centre de ce noyau annulaire (70) est prévu un mandrin (81) en une matière assurant une bonne conduction thermique;

p) les diverses caractéristiques étant adaptées les unes aux autres d'une manière telle que:

chacun des transformateurs convient pour transmettre des impulsions uni- et bipolaires et avec une largeur de bande de transmission de 50 Hz à 1 MHz et présente entre l'enroulement primaire (42; 78, 78') et l'enroulement secondaire (56; 71, 71') une rigidité diélectrique d'au moins 50 kV, un coefficient de couplage d'au moins 0,999 et une capacité inférieure à 250 pF, et dans le cas d'une modulation de 1:2 et une tension de 500 V_ sur l'enroulement primaire, transmet une puissance d'impulsions d'au moins 30 kW.

Fig. 1

Fig. 2

Fig.4

Fig.3